# FASCICULE DE BREVET EUROPEEN

(11) **EP 3 010 023 B1**
(45) Date de publication et mention de la délivrance du brevet: **30.08.2017**
(21) Numéro de dépôt: 15189521.6
(22) Date de dépôt: 13.10.2015
(51) Int. Cl.: G11C 13/00, H01L 45/00

(54) **DISPOSITIF DE MEMOIRE VIVE RESISTIVE**
RESISTIVE ARBEITSSPEICHERVORRICHTUNG
RESISTIVE RANDOM ACCESS MEMORY DEVICE

(30) Priorité: 15.10.2014 FR 1459900
(43) Date de publication de la demande: 20.04.2016
(73) Titulaire: COMMISSARIAT À L'ÉNERGIE ATOMIQUE ET AUX ÉNERGIES ALTERNATIVES, 75015 Paris (FR)
(72) Inventeur: MOLAS, Gabriel, 38000 Grenoble (FR); BARCI, Marinela, 10020 Casalborgone (IT)
(74) Mandataire: Cabinet Camus Lebkiri

(56) Documents cités:
- US-A1- 2012 168 705
- US-A1- 2014 036 570
- US-A1- 2014 269 002

## Description

### DOMAINE TECHNIQUE DE L'INVENTION

La présente invention concerne le domaine des mémoires réinscriptibles non volatiles, et plus spécifiquement celui des mémoires vives résistives. Une mémoire vive résistive comprend des première et seconde électrodes séparées par une couche en matériau électriquement isolant, et passe d'un état isolant à un état conducteur par formation d'un filament conducteur entre les première et seconde électrodes.

### ARRIERE-PLAN TECHNOLOGIQUE DE L'INVENTION

Les mémoires vives à résistance variable (appelées mémoires RRAM pour « Resistive Random Access Memories » en anglais) sont aujourd'hui le sujet d'une grande attention, en raison notamment de leur faible consommation électrique et leur vitesse de fonctionnement élevée.

Une cellule mémoire de type résistive présente au moins deux états : un état fortement résistif « HRS » (« High Resistance State »), appelé également état « OFF », et un état faiblement résistif « LRS » (« Low Resistance State ») ou état « ON ». Elle peut donc être utilisée pour stocker une information binaire.

On peut distinguer trois types de mémoires résistives : les mémoires à base de mécanisme thermochimique, les mémoires à base de changement de valence, et les mémoires à base de métallisation électrochimique.

Le domaine de la présente invention concerne plus particulièrement cette dernière catégorie basée sur des matériaux à conduction ionique (mémoires CBRAM ou « Conductive Bridging RAM »). Le fonctionnement réside dans la formation et la rupture réversibles d'un filament conducteur dans un électrolyte solide, par dissolution d'une électrode soluble. Ces mémoires sont prometteuses de par leur faibles tensions de programmation (de l'ordre du Volt), leur temps de programmation court (<1 µs), leur faible consommation et leur faible coût d'intégration. De plus, ces mémoires peuvent être intégrées dans les niveaux de métallisation de la logique d'un circuit (« above IC »), ce qui permet d'augmenter la densité d'intégration du circuit. Du point de vue de l'architecture, elles requièrent seulement un dispositif de sélection, un transistor ou une diode par exemple.

Le fonctionnement des mémoires CBRAM est basé sur la formation, au sein d'un électrolyte solide, d'un ou plusieurs filaments conducteurs (appelés également « dendrites ») entre deux électrodes, lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament conducteur, de manière à supprimer ou à réduire considérablement la conduction électrique due à la présence du filament.

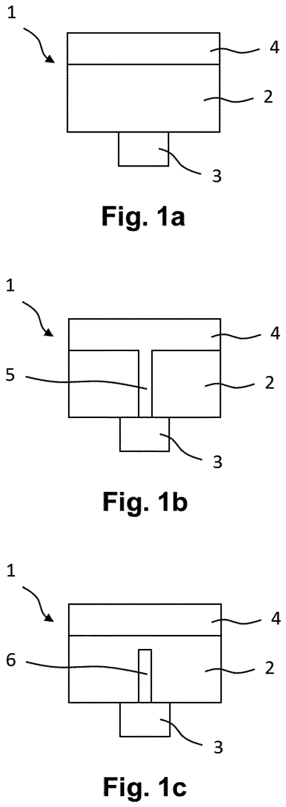

Les figures 1a, 1b et 1c illustrent schématiquement le fonctionnement d'un dispositif mémoire 1 de type CBRAM. Le dispositif mémoire 1 est formé par un empilement de type Métal/Conducteur ionique/Métal. Il comporte un électrolyte solide 2, par exemple à base de chalcogénure dopé (ex. GeS) ou d'oxyde (ex. Al₂O₃). L'électrolyte 2 est disposé entre une électrode inférieure 3, par exemple en Pt, formant une cathode inerte, et une électrode supérieure 4 comportant une portion de métal ionisable, par exemple du cuivre, et formant une anode soluble. Une portion de métal ionisable est une portion de métal pouvant former des ions métalliques, par exemple des ions Cu²⁺ dans le cas où le métal ionisable est du cuivre, lorsqu'elle est soumise à un potentiel électrique approprié. Le dispositif mémoire 1 représenté sur les figures 1a, 1b et 1c forme typiquement un point mémoire, c'est-à-dire une cellule mémoire unitaire, d'une mémoire comportant une multitude de ces dispositifs mémoires.

La figure 1a illustre schématiquement le dispositif mémoire 1 à l'état vierge, avant la première utilisation dudit dispositif mémoire 1, c'est-à-dire avant la première application d'une différence de potentiel entre l'électrode soluble 4 et l'électrode inerte 3 pour le passage du dispositif mémoire 1 à l'état « ON ». La figure 1b illustre schématiquement le dispositif mémoire 1 à l'état « ON ». La figure 1c illustre schématiquement le dispositif mémoire 1 à l'état « OFF ».

La première utilisation du dispositif mémoire 1 permet de passer de l'état vierge à l'état « ON », grâce à la réalisation d'une étape dite de « forming ». L'étape de passage de l'état « ON » à l'état « OFF est appelée « RESET », tandis que l'étape de passage de l'état « OFF » à l'état « ON » est appelée « SET ».

Lorsqu'une différence de potentiel est appliquée entre l'électrode soluble 4 et l'électrode inerte 3, le potentiel électrique appliqué sur l'électrode soluble 4 étant supérieur au potentiel électrique appliqué sur l'électrode inerte 3, une réaction d'oxydo-réduction a lieu à l'électrode soluble 4, créant des ions mobiles. Dans le cas d'une électrode soluble 4 de cuivre, la réaction suivante a lieu :

Cu → Cu²⁺ + 2e⁻.

Les ions mobiles se déplacent alors dans l'électrolyte 2 sous l'effet de la différence de potentiel appliquée entre les électrodes. La vitesse de déplacement dépend de la mobilité de l'ion dans l'électrolyte en question, ce qui guide le choix du couple électrode soluble/électrolyte (exemples : Ag/GeS ; Cu/Al₂O₃...). Les vitesses de déplacement des ions sont de l'ordre du nm/ns. Arrivés à l'électrode inerte 3, les ions mobiles sont réduits de par la présence d'électrons fournis par l'électrode 3, entraînant la croissance d'un filament conducteur 5 selon la réaction suivante :

Cu²⁺ + 2e⁻ → Cu

Le filament conducteur 5 croît préférentiellement dans la direction de l'électrode soluble 4. Le dispositif mémoire 1 passe dans l'état « ON » lorsque le filament 6 permet le contact entre les électrodes 3 et 4, rendant l'empilement conducteur. La figure 1b illustre schématiquement le dispositif mémoire 1 à l'état « ON ».

Une différence de potentiel appliquée entre l'électrode soluble 4 et l'électrode inerte 3, le potentiel électrique appliqué sur l'électrode soluble 4 étant inférieur au potentiel électrique appliqué sur l'électrode inerte 3, entraîne au contraire la dissolution du filament conducteur 5. Pour justifier cette dissolution, des mécanismes thermiques (échauffement) et d'oxydoréduction sont généralement invoqués. Le dispositif mémoire 1 passe alors dans l'état « OFF ». Souvent, l'électrolyte 2 contient dans l'état « OFF » un filament résiduel 6, qui est en contact avec la cathode 3 mais qui n'est pas en contact avec l'anode 4. Le filament résiduel 6 provient d'une dissolution incomplète du filament conducteur 5. Un filament est dit résiduel lorsqu'il n'établit pas une conduction électrique suffisante entre les électrodes pour obtenir l'état « ON ». La figure 1c illustre schématiquement le dispositif mémoire 1 à l'état « OFF ».

Lors de la première utilisation du dispositif mémoire 1, c'est-à-dire lors de la première application d'une différence de potentiel entre l'électrode soluble 4 et l'électrode inerte 3, le filament conducteur 6 est généré pour la première fois : il s'agit de l'étape de forming précédemment mentionnée, qui permet de passer de l'état « vierge » à l'état « ON ». La différence de potentiel requise pour réaliser cette première étape de forming est typiquement plus importante que la différence de potentiel requise par la suite lors des étapes de SET. Par ailleurs, la différence de potentiel nécessaire pour réaliser l'étape de forming peut varier d'un dispositif mémoire à l'autre. Dans une matrice mémoire comportant une pluralité de dispositifs mémoires, il existe ainsi typiquement une distribution une dispersion de la différence de potentiel à appliquer à chaque dispositif mémoire, pour la première formation du filament conducteur au sein de chaque dispositif mémoire. Cette dispersion s'explique notamment par le fait que la différence de potentiel requise pour réaliser la première étape de forming est fonction de la valeur de résistance initiale, notée R0, du dispositif mémoire 1 à l'état vierge. Dans une matrice mémoire comportant une pluralité de dispositifs mémoires, la distribution de la valeur de résistance initiale R0 atteint typiquement plusieurs décades. Lors de l'étape de forming, il est néanmoins très important d'appliquer à chaque dispositif mémoire une différence de potentiel qui lui est ajustée. En effet, l'application d'une différence de potentiel inférieure à la différence de potentiel nominale ne permet pas la première formation du filament conducteur. Au contraire, l'application d'une différence de potentiel supérieure à la différence de potentiel nominale entraîne une dégradation des performances électriques du dispositif mémoire, notamment en termes de fiabilité, de rétention et d'endurance. Afin d'éviter l'application d'une différence de potentiel trop importante sur un dispositif mémoire lors de l'étape de forming, une solution consiste à réaliser successivement plusieurs cycles de forming avec des différences de potentiel croissantes. L'état du dispositif mémoire est lu après chaque cycle afin de connaître son état, c'est-à-dire afin de savoir si le filament conducteur est formé ou non. Si le filament conducteur n'est pas formé, on réalise le cycle suivant. Si le filament conducteur est formé, on arrête le processus pour le dispositif mémoire considéré. Une telle solution implique toutefois un temps de forming élevé, particulièrement dans le cas d'une matrice mémoire comportant une pluralité de dispositifs mémoires, la différence de potentiel à appliquer à chaque dispositif mémoire devant être ajustée pour chacun desdits dispositifs mémoires.

Le document US2012168705 décrit une telle formation du filament conducteur dans un dispositif de mémoire résistive.

### RESUME DE L'INVENTION

Dans ce contexte, un objectif de l'invention est de proposer un procédé de première formation du filament conducteur, tel que définit par la revendication 1, dans un dispositif mémoire CBRAM à base d'oxyde métallique permettant d'accélérer l'étape de forming tout en préservant les performances électriques dudit dispositif mémoire.

Un autre objectif de l'invention est de proposer un procédé de première formation du filament conducteur dans un dispositif mémoire CBRAM à base d'oxyde métallique permettant d'accélérer l'étape de forming tout en améliorant les performances électriques dudit dispositif mémoire.

Un aspect de l'invention concerne ainsi un dispositif de mémoire vive résistive comportant :
- une première électrode, dite « électrode inerte » ;
- un électrolyte solide en oxyde métallique ;
- une deuxième électrode, dite « électrode soluble », les première et deuxième électrodes étant respectivement agencées de part et d'autre dudit électrolyte solide en oxyde métallique, la deuxième électrode étant apte à fournir des ions mobiles circulant dans l'électrolyte solide en oxyde métallique vers la première électrode pour former un filament conducteur entre les première et deuxième électrodes lorsqu'une différence de potentiel est appliquée entre les première et deuxième électrodes ;
ledit dispositif comportant une couche d'interface comprenant un oxyde métallique, la couche d'interface s'étendant au moins partiellement sur la première électrode, l'électrolyte solide en oxyde métallique s'étendant au moins partiellement sur la couche d'interface.

Grâce à l'invention, la couche d'interface comprenant un oxyde métallique se comporte avantageusement comme une source de lacunes d'oxygène pour l'électrolyte solide en oxyde en métallique, en ayant tendance à attirer, ou pomper, un ou plusieurs éléments oxygène de l'électrolyte solide en oxyde métallique qui s'étend au moins partiellement sur ladite couche d'interface. La couche d'interface permet avantageusement la génération d'un chemin localisé de lacunes d'oxygène au sein de l'électrolyte solide en oxyde métallique, entre l'électrode soluble et l'électrode inerte.

Outre les caractéristiques qui viennent d'être évoquées dans le paragraphe précédent, le dispositif de mémoire vive résistive selon un aspect de l'invention peut présenter une ou plusieurs caractéristiques complémentaires parmi les suivantes, considérées individuellement ou selon toutes les combinaisons techniquement possibles :
- L'oxyde métallique de la couche d'interface est un oxyde métallique sous-stoechiométrique de formule MOₓ, avec M un métal, O l'oxygène et 1<x<2.
- L'oxyde métallique de la couche d'interface est un oxyde métallique sous-stoechiométrique de formule MO_{X}, avec M un métal, O l'oxygène et 1,6<x<1,9.
- L'oxyde métallique de la couche d'interface est un oxyde métallique d'un métal de transition des groupes 3, 4, 5 ou 6 du tableau périodique des éléments.
- Le métal de transition des groupes 3, 4, 5 ou 6 du tableau périodique des éléments est du titane Ti. Alternativement, le métal de transition des groupes 3, 4, 5 ou 6 du tableau périodique des éléments est de l'hafnium Hf ou du zirconium Zr.
- La couche d'interface s'étendant suivant un plan de référence, la couche d'interface présente une épaisseur comprise entre 0,5 nm et 2 nm, ladite épaisseur étant mesurée suivant une direction sensiblement perpendiculaire audit plan de référence.

Un autre aspect de l'invention concerne un procédé de première formation du filament conducteur dans un dispositif de mémoire vive résistive selon l'une quelconque des revendications précédentes, le procédé comportant :
- une étape dite « de pré-forming » selon laquelle, le dispositif de mémoire vive résistive étant dans un premier état isolant et présentant une première résistance R1, un premier potentiel électrique V1 est appliqué sur la première électrode et un deuxième potentiel électrique V2 est appliqué sur la deuxième électrode, le deuxième potentiel électrique V2 étant inférieur au premier potentiel électrique V1, pour la formation d'un chemin localisé de lacunes d'oxygène entre les première et deuxième électrodes, le dispositif de mémoire vive résistive à l'issue de ladite étape de pré-forming étant dans un deuxième état isolant et présentant une deuxième résistance R2 inférieure à la première résistance R1 ;
- une étape dite « de forming » selon laquelle, le dispositif de mémoire vive résistive étant dans le deuxième état isolant, un premier potentiel électrique V1' est appliqué sur la première électrode et un deuxième potentiel électrique V2' est appliqué sur la deuxième électrode, le deuxième potentiel électrique V2' étant supérieur au premier potentiel électrique V1', pour la formation du filament conducteur entre les première et deuxième électrodes, le dispositif de mémoire vive résistive à l'issue de ladite étape de forming étant dans un état passant.

Outre les caractéristiques qui viennent d'être évoquées dans le paragraphe précédent, le procédé de première formation du filament conducteur selon un aspect de l'invention peut présenter une ou plusieurs caractéristiques complémentaires parmi les suivantes, considérées individuellement ou selon toutes les combinaisons techniquement possibles :
- Lors de l'étape de pré-forming, la valeur du premier potentiel électrique V1 qui est appliqué à la première électrode et la valeur du deuxième potentiel V2 qui est appliqué à la deuxième électrode sont choisies de manière que le rapport R1/R2 de la première résistance R1 sur la deuxième résistance R2 est de l'ordre de 10³.

Un autre aspect de l'invention concerne un procédé de programmation d'une matrice mémoire comportant une pluralité de dispositifs de mémoire vive résistive selon un aspect de l'invention, ledit procédé comportant, pour chaque dispositif de mémoire vive résistive de la matrice mémoire, une étape de mise en oeuvre du procédé de première formation du filament conducteur selon un aspect de l'invention.

Outre les caractéristiques qui viennent d'être évoquées dans le paragraphe précédent, le procédé de programmation d'une matrice mémoire comportant une pluralité de dispositifs de mémoire vive résistive selon un aspect de l'invention peut présenter une ou plusieurs caractéristiques complémentaires parmi les suivantes, considérées individuellement ou selon toutes les combinaisons techniquement possibles :
- Lors de chaque étape de pré-forming de chaque dispositif de mémoire vive résistive de la matrice mémoire, le premier potentiel électrique V1 et le deuxième potentiel électrique V2 sont propres à chaque dispositif de mémoire vive résistive, et lors de chaque étape de forming de chaque dispositif de mémoire vive résistive de la matrice mémoire, le premier potentiel électrique V1' et le deuxième potentiel électrique V2' sont propres à chaque dispositif de mémoire vive résistive.
- Alternativement, le procédé comporte une étape dite « de pré-forming général » selon laquelle, la matrice mémoire étant dans un premier état isolant moyen et présentant une première résistance moyenne, un même premier potentiel électrique est appliqué sur la première électrode et un même deuxième potentiel électrique est appliqué sur la deuxième électrode de chaque dispositif de mémoire vive résistive de la matrice mémoire pour la formation d'un chemin localisé de lacunes d'oxygène entre les première et deuxième électrodes de chaque dispositif de mémoire vive résistive de la matrice mémoire, la matrice mémoire à l'issue de ladite étape de pré-forming général étant dans un deuxième état isolant moyen et présentant une deuxième résistance moyenne inférieure à la première résistance moyenne.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1a illustre schématiquement un dispositif mémoire de type CBRAM selon l'état de la technique, dans un état « vierge ».
- La figure 1b illustre schématiquement un dispositif mémoire de type CBRAM selon l'état de la technique, dans un état « ON ».
- La figure 1c illustre schématiquement un dispositif mémoire de type CBRAM selon l'état de la technique, dans un état « OFF »
- La figure 2 illustre schématiquement un dispositif mémoire de type CBRAM à base d'oxyde métallique selon un aspect de l'invention, dans un premier état isolant.
- La figure 3a illustre schématiquement une étape, dite « de pré-forming », d'un procédé de première formation d'un filament conducteur dans le dispositif mémoire CBRAM à base d'oxyde métallique de la figure 2.
- La figure 3b illustre schématiquement une étape, dite « de forming », du procédé de première formation d'un filament conducteur dans le dispositif mémoire CBRAM à base d'oxyde métallique de la figure 2.
- La figure 3c illustre schématiquement une étape, dite « de RESET », d'un procédé d'utilisation du dispositif mémoire CBRAM à base d'oxyde métallique de la figure 2.
- La figure 4a est un graphique montrant, pour une pluralité de dispositifs mémoires de type CBRAM selon l'état de la technique, la distribution des valeurs de résistance avant l'étape de forming.
- La figure 4b est un graphique montrant, pour une pluralité de dispositifs mémoires de type CBRAM selon l'état de la technique, la distribution des valeurs requises de différence de potentiel pour réaliser l'étape de forming.
- La figure 4c est un graphique montrant, pour une pluralité de dispositifs mémoires de type CBRAM selon l'état de la technique, la distribution des valeurs de résistance à l'issue de l'étape de forming.
- La figure 5a est un graphique montrant, pour une pluralité de dispositifs mémoires CBRAM à base d'oxyde métallique selon un aspect de l'invention, la distribution des valeurs de résistance avant l'étape de pré-forming.
- La figure 5b est un graphique montrant, pour une pluralité de dispositifs mémoires CBRAM à base d'oxyde métallique selon un aspect de l'invention, la distribution des valeurs de résistance à l'issue de l'étape de pré-forming.
- La figure 5c est un graphique montrant, pour une pluralité de dispositifs mémoires CBRAM à base d'oxyde métallique selon un aspect de l'invention, la distribution des valeurs requises de différence de potentiel pour réaliser l'étape de forming, l'étape de pré-forming ayant été réalisée.
- La figure 5d est un graphique montrant, pour une pluralité de dispositifs mémoires CBRAM à base d'oxyde métallique selon un aspect de l'invention, la distribution des valeurs de résistance à l'issue de l'étape de forming, l'étape de pré-forming ayant été réalisée.

### DESCRIPTION DETAILLEE D'AU MOINS UN MODE DE REALISATION DE L'INVENTION

Sauf précision contraire, un même élément apparaissant sur des figures différentes présente une référence unique.

Dans la présente description, on emploiera indifféremment les expressions « cellule mémoire CBRAM », « dispositif mémoire de type CBRAM » et « dispositif de mémoire vive résistive ».

Les figures 1a, 1b et 1c, qui illustrent schématiquement un dispositif mémoire 1 de type CBRAM selon l'état de la technique, ont été précédemment décrites.

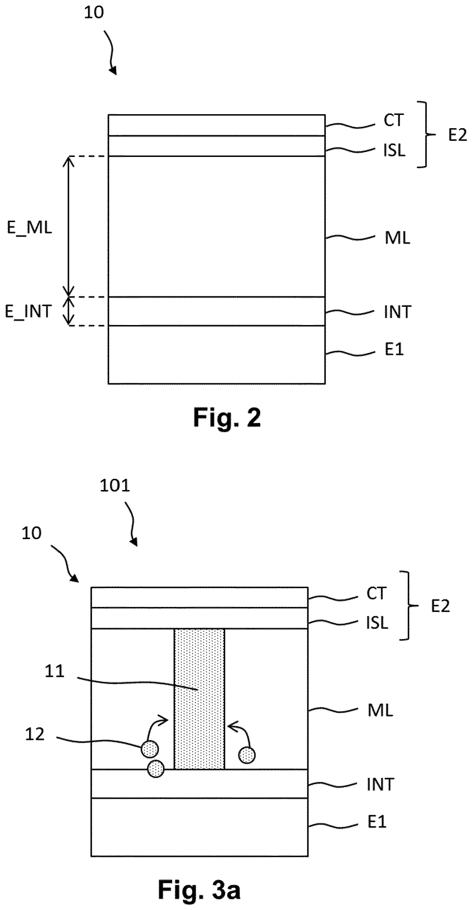

La figure 2 illustre schématiquement un dispositif mémoire 10 de type CBRAM à base d'oxyde métallique selon un aspect de l'invention, dans un premier état isolant. Le dispositif mémoire 10 selon un aspect de l'invention comporte :
- une première électrode E1, également appelée «électrode inerte» ou « cathode », s'étendant suivant un plan de référence ;
- une couche d'interface INT s'étendant au moins partiellement sur la première électrode E1, parallèlement au plan de référence ;
- un électrolyte solide ML en oxyde métallique, s'étendant sur la couche d'interface INT, parallèlement au plan de référence ;
- une deuxième électrode E2, également appelée « électrode soluble » ou « anode », s'étendant sur l'électrolyte solide ML en oxyde métallique, parallèlement au plan de référence.
La deuxième électrode E2 comprend préférentiellement :
- une première couche ISL, dite « couche de source d'ions » réalisée à partir d'un élément conducteur soluble et s'étendant sur l'électrolyte solide ML en oxyde métallique ;
- une deuxième couche CT, dite « couche de contact électrique », réalisée à partir d'un matériau conducteur et s'étendant au moins partiellement sur la couche de source d'ions ISL.
Le dispositif mémoire 10 dans le premier état isolant présente une première résistance R1. Le premier état isolant est l'état du dispositif mémoire 10 avant la première formation d'un filament conducteur au sein dudit dispositif mémoire 10.

La première électrode E1 est réalisée en un matériau conducteur inerte, c'est-à-dire ne participant pas à la formation d'un filament conducteur au sein de l'électrolyte solide ML en oxyde métallique. Ce matériau conducteur inerte peut typiquement être :
- du ruthénium Ru,
- du dioxyde de ruthénium RuO₂,
- du tungstène W,
- du nitrure de tungstène WNₓ,
- du nitrure de tantale TaN,
- du nitrure de titane TiN, ou tout alliage ou combinaison des éléments qui viennent d'être cités.
Selon une alternative non représentée à la figure 2, la première électrode E1 peut présenter une forme de plot. Selon cette alternative, la couche d'interface INT s'étend partiellement sur la première électrode E1.

La couche d'interface INT est une source de lacunes d'oxygène comprenant un oxyde métallique. On entend par « source de lacune d'oxygène » le fait que la couche d'interface INT a tendance à attirer, ou pomper, un ou plusieurs éléments oxygène de l'électrolyte solide ML en oxyde métallique. Lorsque la couche d'interface INT prend un élément oxygène de l'électrolyte solide ML en oxyde métallique, il y a création d'une lacune d'oxygène dans l'électrolyte solide ML en oxyde métallique.
L'oxyde métallique de la couche d'interface INT est préférentiellement un oxyde métallique sous-stoechiométrique de formule MOₓ, avec M un métal, O l'oxygène et 1 < x < 2. En particulier, l'oxyde métallique de la couche d'interface INT est préférentiellement un oxyde sous-stoechiométrique de formule MOₓ avec M le métal, O l'oxygène et 1,6 < x < 1,9.
L'oxyde métallique de la couche d'interface INT est préférentiellement un oxyde métallique d'un métal de transition du tableau périodique des éléments. En particulier, l'oxyde métallique de la couche d'interface INT est préférentiellement un oxyde métallique d'un métal de transition des groupes 3, 4, 5 ou 6 du tableau périodique des éléments. Ainsi, l'oxyde métallique de la couche d'interface INT peut notamment être un oxyde de titane, un oxyde d'hafnium ou un oxyde de zirconium. Alternativement, l'oxyde métallique de la couche d'interface INT peut également être un oxyde d'aluminium.
La couche d'interface INT présente typiquement une épaisseur E_INT, mesurée suivant une direction perpendiculaire au plan de référence, comprise entre 0,5 nm et 2 nm.

Dans l'exemple particulier représenté à la figure 2, l'électrolyte solide ML en oxyde métallique est réalisé en oxyde de gadolinium Gd₂O₃. En particulier, l'électrolyte solide ML en oxyde métallique peut être réalisé en oxyde de gadolinium Gd₂O₃ hybride, c'est-à-dire comportant au moins une première sous-couche en oxyde de gadolinium Gd₂O₃ et une deuxième sous-couche en oxyde de gadolinium Gd₂O₃. La première sous-couche est une sous-couche standard formée par pulvérisation RF utilisant un gaz d'argon Ar, de xénon Xe ou de krypton Kr. La deuxième sous-couche est une couche en oxyde de gadolinium Gd₂O₃ sous-stoechiométrique, obtenue à partir d'une cible de gadolinium Gd en dépôt réactif sous oxygène..

Lesdites première et deuxième sous-couches sont, au moins partiellement, directement en contact l'une avec l'autre, et lesdites première et deuxième sous-couches sont typiquement sensiblement de même épaisseur.
Alternativement, les configurations suivantes, considérées individuellement ou selon toutes les combinaisons techniquement possibles, pourront être adoptées :
- l'électrolyte solide ML en oxyde métallique est réalisé en oxyde d'aluminium Al₂O₃, du dioxyde de zirconium ZrO₂, du dioxyde de titane TiO₂ ou de l'oxyde de tantale Ta₂O₅ ;
- l'électrolyte solide ML en oxyde métallique comporte au moins une bicouche de type Gd₂O₃/Al₂O₃, Gd₂O₃/GeO, Gd₂O₃/La₂O₃, Gd₂O₃/Li₂O, Gd₂O₃/B₂O₃, Gd₂O₃/WO₂, Gd₂O₃/VO₂, Gd₂O₃/V₂O_{5,} Gd₂O₃/MgO ou Gd₂O₃/MgAl₂O₄ ;
- l'électrolyte solide ML en oxyde métallique comporte au moins une tricouche de type Gd₂O₃/Al₂O₃/Gd₂O₃, Gd₂O₃/GeO/Gd₂O₃, Gd₂O₃/La₂O₃/Gd₂O₃, Gd₂O₃/Li₂O/Gd₂O₃, Gd₂O₃/B₂O₃/Gd₂O₃, Gd₂O₃/WO₂/Gd₂O₃, Gd₂O₃/VO₂/Gd₂O₃, Gd₂O₃/V₂O₅/Gd₂O₃, Gd₂O₃/MgO/Gd₂O₃, Gd₂O₃/MgAl₂O₄/Gd₂O₃.
L'électrolyte solide ML en oxyde métallique présente typiquement une épaisseur E_ML, mesurée suivant une direction perpendiculaire au plan de référence, de l'ordre de quelques nanomètres. L'épaisseur E_ML de l'électrolyte solide ML est typiquement choisie de manière que la première résistance R1 du dispositif mémoire 10 dans le premier état isolant soit supérieure ou égale à 10⁹ ohms.

La couche de source d'ions ISL de la deuxième électrode E2 est réalisée en un matériau conducteur soluble, c'est-à-dire participant à la formation d'un filament conducteur au sein de l'électrolyte solide ML en oxyde métallique. Ce matériau conducteur soluble peut être par exemple :
- du cuivre Cu ;
- un alliage de cuivre Cu avec un élément chalcogène tel que du tellure Te ;
- du zinc Zn ;
- de l'argent Ag ;
- du nitrure de cuivre Cu₃N ;
- du nitrure de zinc Zn₃N₂ ;
- du nitrure d'argent Ag₃N.

La couche de contact électrique CT de la deuxième électrode E2 est réalisée à partir d'un matériau conducteur, tel que par exemple du Ti-TiN, c'est-à-dire une couche de Ti et une couche de TiN, ou du Ta-TaN, c'est-à-dire une couche de Ta et une couche de TaN.

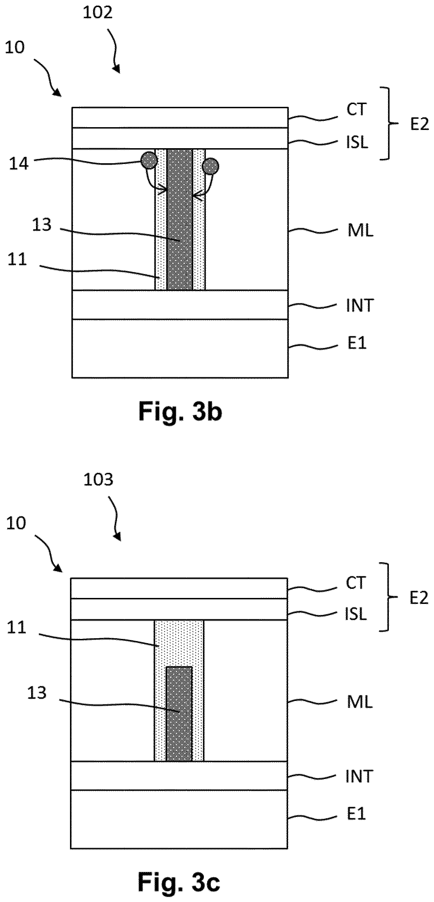

Les figures 3a et 3b illustrent schématiquement des étapes d'un procédé de première formation d'un filament conducteur dans le dispositif mémoire 10 selon un aspect de l'invention.
La figure 3a illustre schématiquement une étape 101, dite «de pré-forming ». Avant l'étape 101 de pré-forming, le dispositif mémoire 10 est dans le premier état isolant et présente la première résistance R1, ainsi que précédemment décrit. Lors de l'étape 101 de pré-forming, un premier potentiel électrique V1 est appliqué sur la première électrode E1 et un deuxième potentiel électrique V2 est appliqué sur la deuxième électrode E2, le deuxième potentiel électrique V2 étant inférieur au premier potentiel électrique V1, pour la formation d'un chemin localisé 11 de lacunes d'oxygène 12. On note que dans le cas où le premier potentiel électrique V1 est nul, le deuxième potentiel électrique V2 est négatif. A l'issue de l'étape 101 de pré-forming, le dispositif mémoire 10 est dans un deuxième état isolant et présente une deuxième résistance R2 qui est inférieure à la première résistance R1. Le deuxième état isolant est également appelé état « OFF », ou état « HRS » (de l'anglais « High Resistive State »). La différence de potentiel qui est appliquée au dispositif mémoire 10 lors de l'étape 101 de pré-forming est avantageusement choisie de manière que le rapport R1/R2 de la première résistance R1 sur la deuxième résistance R2 soit de l'ordre de 10³. Ainsi, dans le cas où la première résistance R1 est de l'ordre de 10⁹ ohms, la différence de potentiel qui est appliquée au dispositif mémoire 10 lors de l'étape 101 de pré-forming est avantageusement choisie de manière que la deuxième résistance R2 soit de l'ordre de 10⁶ ohms.

La figure 3b illustre schématiquement une étape 102, dite « de forming ». Avant l'étape 102 de forming, le dispositif mémoire 10 est dans le deuxième état isolant et présente la deuxième résistance R2. Lors de l'étape 102 de forming, un premier potentiel électrique V1' est appliqué sur la première électrode E1 et un deuxième potentiel électrique V2' est appliqué sur la deuxième électrode E2, le deuxième potentiel électrique V2' étant supérieur au premier potentiel électrique V1', pour la formation d'un filament conducteur 13. Le filament conducteur 13 est formé à partir d'ions mobiles 14. Les ions mobiles 14 sont créés au niveau de l'électrode soluble E2 par une réaction d'oxydo-réduction, puis se déplacent dans l'électrolyte solide ML sous l'effet de la différence de potentiel appliquée entre les électrodes, avant d'être réduits au niveau de l'électrode inerte E1, entraînant la croissance du filament conducteur 13 entre l'électrode inerte E1 et l'électrode soluble E2. On note que dans le cas où le premier potentiel électrique V1' est nul, le deuxième potentiel électrique V2' est positif. A l'issue de l'étape 102 de forming, le dispositif mémoire 10 est dans un état passant et présente une troisième résistance R3 qui est inférieure aux première et deuxième résistances R1 et R2. La troisième résistance R3 est typiquement de l'ordre 10³ ohms. L'état passant est également appelé état « ON » ou état « LRS » (de l'anglais « Low Resistive State »).

D'une manière générale, plus la valeur de la résistance d'un dispositif mémoire est faible, plus la différence de potentiel U_{FORM} = (V2' - V1') requise pour réaliser l'étape 102 de forming est abaissée. Lorsque la résistance d'un dispositif mémoire donné est suffisamment faible, un cas très intéressant peut être atteint pour lequel la différence de potentiel U_{FORM} requise pour réaliser l'étape 102 de forming est égale à la différence de potentiel U_{SET} requise pour réaliser une étape de SET, telle que précédemment décrite. Ce type de fonctionnement est également appelé « forming free » : la différence de potentiel de forming, lors de la première formation du filament conducteur, est égale à la différence de potentiel de SET, lors des formations ultérieures du filament conducteur. Le procédé selon l'invention de première formation d'un filament conducteur au sein d'un dispositif mémoire 10 permet avantageusement, grâce à l'étape 101 de pré-forming, d'abaisser la valeur de la résistance dudit dispositif mémoire 10, en passant de la première résistance R1 à la deuxième résistance R2, tout en conservant le dispositif mémoire 10 dans un état isolant. Le procédé selon l'invention de première formation d'un filament conducteur au sein d'un dispositif mémoire 10 permet également, grâce à l'étape 101 de pré-forming, de contrôler la valeur de la deuxième résistance R2, et donc de contribuer à contrôler la valeur de la différence de potentiel U_{FORM} requise pour réaliser l'étape 102 de forming. Ainsi, dans le cas d'une matrice mémoire comportant une pluralité de dispositifs mémoires 10 selon un aspect de l'invention, on diminue avantageusement la dispersion des valeurs de différence de potentiel U_{FORM} requises pour réaliser l'étape 102 de forming.

La figure 3c illustre schématiquement une étape 103, dite « de RESET », d'un procédé d'utilisation du dispositif mémoire 10 selon un aspect de l'invention. Ledit procédé d'utilisation comporte avantageusement l'étape 101 de pré-forming, l'étape 102 de forming et l'étape 103 de RESET. Avant l'étape 103 de RESET, le dispositif mémoire 10 est dans l'état passant, c'est-à-dire dans l'état LRS ou « ON », grâce au filament conducteur 13 entre l'électrode inerte E1 et l'électrode soluble E2. Lors de l'étape 103 de RESET, un premier potentiel électrique V1" est appliqué sur la première électrode E1 et un deuxième potentiel électrique V2" est appliqué sur la deuxième électrode E2, le deuxième potentiel électrique V2" étant inférieur au premier potentiel électrique V1", pour la dissolution au moins partielle du filament conducteur 13. On note que dans le cas où le premier potentiel électrique V1" est nul, le deuxième potentiel électrique V2" est négatif. A l'issue de l'étape 103 de RESET, le dispositif mémoire 10 est dans le deuxième état isolant, c'est-à-dire dans l'état HRS ou « OFF ». A l'issue de l'étape 103 de RESET, le filament conducteur 13 peut être complètement dissous : dans ce cas, le dispositif mémoire 10 présente la deuxième résistance R2. A l'issue de l'étape 103 de RESET, le filament 13 peut alternativement être partiellement dissous : dans ce cas, le dispositif mémoire 10 présente typiquement une résistance qui est un peu inférieure à la deuxième résistance R2, tout en étant de l'ordre de la deuxième résistance R2. D'une manière générale, à l'issue de l'étape 103 de RESET, le dispositif mémoire 10 est dans un état isolant avec une résistance inférieure à la première résistance R1 du premier état isolant. On note que le chemin localisé 11 de lacunes d'oxygène 12 n'est pas dissous lors de l'étape 103 de RESET. Une fois formé dans le dispositif mémoire 10 grâce à l'étape 101 de pré-forming, le chemin localisé 11 de lacunes d'oxygène 12 demeure de manière permanente dans le dispositif mémoire 10 utilisé en conditions normales d'utilisation. On entend par « le chemin localisé 11 de lacunes d'oxygène 12 demeure de manière permanente dans le dispositif mémoire 10 » le fait que, d'un cycle mémoire à l'autre, ledit chemin localise 11 de lacunes d'oxygène 12 est peu ou pas modifié : il est possible que la concentration de lacunes d'oxygène 12 du chemin localisé 11 varie sensiblement au cours des différents cycles « ON »/« OFF » du dispositif mémoire 10. On entend par « conditions normales d'utilisation » les conditions permettant de faire passer le dispositif mémoire 10 de son état « ON » à son état « OFF », grâce à l'étape de RESET qui vient d'être décrite, ainsi que de son état « OFF » à son état « ON », grâce à une étape dite « de SET » qui est à présent décrite.

Le procédé d'utilisation du dispositif mémoire 10 selon un aspect de l'invention peut ensuite typiquement comporter une étape de SET, non représentée. Avant l'étape de SET, le dispositif mémoire 10 est dans le deuxième état isolant, c'est-à-dire dans l'état HRS ou « OFF » . Avant l'étape de SET, le dispositif mémoire 10 comporte donc le chemin localisé 11 de lacunes d'oxygène 12 entre l'électrode soluble E2 et l'électrode inerte E1, tandis que le filament conducteur 13 est partiellement ou complètement dissous. Ainsi que précédemment décrit :
- dans le cas où le filament conducteur 13 est complètement dissous, le dispositif mémoire 10 présente typiquement la deuxième résistance R2,
- tandis que dans le cas où le filament conducteur 13 est partiellement dissous, le dispositif mémoire 10 présente typiquement une résistance inférieure à la deuxième résistance R2, tout en étant de l'ordre de la deuxième résistance R2.
Lors de l'étape de SET, un premier potentiel électrique V1''' est appliqué sur la première électrode E1 et un deuxième potentiel électrique V2''' est appliqué sur la deuxième électrode E2, le deuxième potentiel électrique V2''' étant supérieur au premier potentiel électrique V1''', afin de reformer complètement le filament conducteur 13 entre l'électrode inerte E1 et l'électrode soluble E2. On note que dans le cas où le premier potentiel électrique V1''' est nul, le deuxième potentiel électrique V2''' est positif. A l'issue de l'étape de SET, le dispositif mémoire 10 est dans l'état passant, c'est-à-dire dans l'état LRS ou « ON », et présente la troisième résistance R3. On note que la différence de potentiel U_{SET} = (V2''' - V1''') qui est appliquée au dispositif mémoire 10 lors de l'étape de SET est inférieure ou égale à la différence de potentiel U_{FORM} = (V2' - V1') qui est appliquée au dispositif mémoire 10 lors de l'étape 102 de forming. Dans le cas où le dispositif mémoire 10 présente, avant l'étape de SET, la deuxième résistance R2, c'est-à-dire dans le cas où le filament conducteur 13 a été complètement dissous lors de la précédente étape 103 de RESET, on a alors typiquement: U_{FORM} = U_{SET}. Dans le cas où le dispositif mémoire 10 présente, avant l'étape de SET, une résistance inférieure à la deuxième résistance R2, c'est-à-dire dans le cas où le filament conducteur 13 a été partiellement dissous lors de la précédente étape 103 de RESET, on a alors typiquement U_{SET} < U_{FORM}.

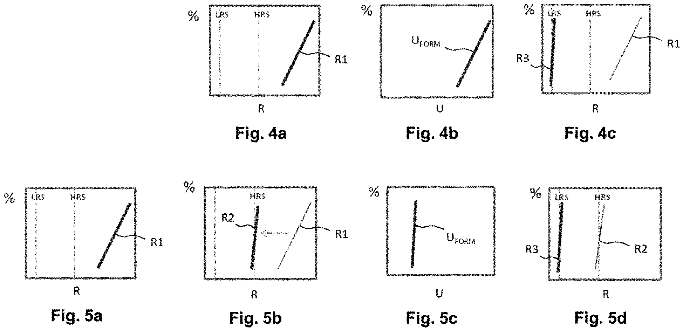

La figure 4a est un graphique montrant, pour une première pluralité de dispositifs mémoires selon l'état de la technique, la distribution des valeurs de première résistance R1 avant la première formation d'un filament conducteur au sein de chacun desdits dispositifs mémoires selon l'état de la technique, c'est-à-dire avant l'étape de forming.
La figure 4b est un graphique montrant, pour la première pluralité de dispositifs mémoires selon l'état de la technique, la distribution des différences de potentiel U_{FORM} requises pour réaliser l'étape de forming.
La figure 4c est un graphique montrant, pour la première pluralité de dispositifs mémoires selon l'état de la technique, la distribution des valeurs de troisième résistance R3 à l'issue de l'étape de forming. La figure 4c montre un premier écart ec1 entre la droite des valeurs de première résistance R1 et la droite des valeurs de troisième résistance R3, pour la première pluralité de dispositifs mémoires selon l'état de la technique.

La figure 5a est un graphique montrant, pour une deuxième pluralité de dispositifs mémoires 10 selon un aspect de l'invention, la distribution des valeurs de première résistance R1 avant la première formation d'un filament conducteur au sein de chacun desdites dispositifs mémoires 10 selon un aspect de l'invention, c'est-à-dire avant l'étape 101 de pré-forming. On constate que ladite distribution des valeurs de première résistance R1 pour la deuxième pluralité est sensiblement identique à la distribution des valeurs de première résistance R1 pour la première pluralité.

La figure 5b est un graphique montrant, pour la deuxième pluralité de dispositifs mémoires 10 selon un aspect de l'invention, la distribution des valeurs de deuxième résistance R2 à l'issue de l'étape de pré-forming. La figure 5b montre :
- d'une part, que les valeurs de deuxième résistance R2 sont inférieures aux valeurs de première résistance R1, ce qui se traduit sur le graphique 5b par le fait que la droite des valeurs de deuxième résistance R2 est décalée vers la gauche par rapport à la droite des valeurs de première résistance R1 ;
- et d'autre part, que la dispersion des valeurs de deuxième résistance R2 est inférieure à la dispersion des valeurs de première résistance R1, ce qui se traduit sur le graphique 5b par le fait que la droite des valeurs de deuxième résistance R2 présente une pente supérieure à la pente de la droite des valeurs de première résistance R1.

La figure 5c est un graphique montrant, pour la deuxième pluralité de dispositifs mémoires 10 selon un aspect de l'invention, la distribution des différences de potentiel U_{FORM} requises pour réaliser l'étape 102 de forming, l'étape 101 de pré-forming ayant été réalisée. On constate :
- d'une part, que les valeurs de différence de potentiel U_{FORM} pour la deuxième pluralité sont inférieures aux valeurs de différence de potentiel potentiel U_{FORM} pour la première pluralité, ce qui se traduit par le fait que la droite des valeurs de différence de potentiel U_{FORM} pour la deuxième pluralité, représentée en figure 5c, est décalée vers la gauche par rapport à la droite des valeurs de différence de potentiel U_{FORM} pour la première pluralité, représentée en figure 4b ;
- et d'autre part, que la dispersion des valeurs de différence de potentiel U_{FORM} pour la deuxième pluralité est inférieure à la dispersion des valeurs de différence de potentiel U_{FORM} pour la première pluralité, ce qui se traduit par le fait que la droite des valeurs de différence de potentiel U_{FORM} pour la deuxième pluralité, représentée en figure 5c, présente une pente supérieure à la pente de la droite des valeurs de différence de potentiel U_{FORM} pour la première pluralité, représentée en figure 4b.

La figure 5d est un graphique montrant, pour la deuxième pluralité de dispositifs mémoires 10 selon un aspect de l'invention, la distribution des valeurs de troisième résistance R3 à l'issue de l'étape 102 de forming, l'étape 101 de pré-forming ayant été réalisée. Ladite distribution des valeurs de troisième résistance R3 pour la deuxième pluralité est sensiblement identique à la distribution des valeurs de troisième résistance R3 pour la première pluralité.

## Revendications

1. Procédé de première formation d'un filament conducteur (13) dans un dispositif (10) de mémoire vive résistive, le dispositif de mémoire vive résistive comportant :
- une première électrode (E1), dite « électrode inerte » ;
- un électrolyte solide en oxyde métallique (ML) ;
- une deuxième électrode (E2), dite « électrode soluble », les première et deuxième électrodes étant respectivement agencées de part et d'autre dudit électrolyte solide en oxyde métallique (ML), la deuxième électrode (E2) étant apte à fournir des ions mobiles (14) circulant dans l'électrolyte solide en oxyde métallique (ML) vers la première électrode (E1) pour former un filament conducteur (13) entre les première et deuxième électrodes lorsqu'une différence de potentiel est appliquée entre les première et deuxième électrodes ;
- une couche d'interface (INT) comprenant un oxyde métallique, la couche d'interface (INT) s'étendant au moins partiellement sur la première électrode (E1), l'électrolyte solide en oxyde métallique (ML) s'étendant au moins partiellement sur la couche d'interface (INT) ;
le procédé étant **caractérisé en ce qu'**il comporte :
- une étape (101) dite «de pré-forming » selon laquelle, le dispositif de mémoire vive résistive étant dans un premier état isolant et présentant une première résistance R1, un premier potentiel électrique V1 est appliqué sur la première électrode (E1) et un deuxième potentiel électrique V2 est appliqué sur la deuxième électrode (E2), le deuxième potentiel électrique V2 étant inférieur au premier potentiel électrique V1, pour la formation d'un chemin localisé (11) de lacunes d'oxygène (12) entre les première et deuxième électrodes, le dispositif de mémoire vive résistive à l'issue de ladite étape de pré-forming étant dans un deuxième état isolant et présentant une deuxième résistance R2 inférieure à la première résistance R1 ;
- une étape (102) dite « de forming » selon laquelle, le dispositif de mémoire vive résistive étant dans le deuxième état isolant, un premier potentiel électrique V1' est appliqué sur la première électrode (E1) et un deuxième potentiel électrique V2' est appliqué sur la deuxième électrode (E2), le deuxième potentiel électrique V2' étant supérieur au premier potentiel électrique V1', pour la formation du filament conducteur (6) entre les première et deuxième électrodes, le dispositif de mémoire vive résistive à l'issue de ladite étape de forming étant dans un état passant.

2. Procédé selon la revendication précédente **caractérisé en ce que** l'oxyde métallique de la couche d'interface (INT) est un oxyde métallique sous-stoechiométrique de formule MOₓ, avec M un métal, O l'oxygène et 1<x<2.

3. Procédé selon la revendication précédente **caractérisé en ce que** 1,6<x<1,9.

4. Procédé selon l'une quelconque des revendications précédentes **caractérisé en ce que** l'oxyde métallique de la couche d'interface (INT) est un oxyde métallique d'un métal de transition des groupes 3, 4, 5 ou 6 du tableau périodique des éléments.

5. Procédé selon la revendication précédente **caractérisé en ce que** le métal de transition des groupes 3, 4, 5 ou 6 du tableau périodique des éléments est du titane Ti, de l'hafnium Hf ou du zirconium Zr.

6. Procédé selon l'une quelconque des revendications précédentes, dans lequel la couche d'interface (INT) s'étend suivant un plan de référence, **caractérisé en ce que** la couche d'interface (INT) présente une épaisseur comprise entre 0,5 nm et 2 nm, ladite épaisseur étant mesurée suivant une direction sensiblement perpendiculaire audit plan de référence.

7. Procédé selon la revendication précédente **caractérisé en ce que** lors de l'étape (101) de pré-forming, la valeur du premier potentiel électrique V1 qui est appliqué à la première électrode (E1) et la valeur du deuxième potentiel V2 qui est appliqué à la deuxième électrode (E2) sont choisies de manière que le rapport R1/R2 de la première résistance R1 sur la deuxième résistance R2 est de l'ordre de 10³.

8. Procédé de programmation d'une matrice mémoire comportant une pluralité de dispositifs (10) de mémoire vive résistive, ledit procédé comportant, pour chaque dispositif (10) de mémoire vive résistive de la matrice mémoire, une étape de mise en oeuvre du procédé de première formation du filament conducteur dans un dispositif de mémoire vive résistive selon l'une quelconque des revendications 1 à 7.

9. Procédé selon la revendication précédente **caractérisé en ce que** :
- lors de chaque étape (101) de pré-forming de chaque dispositif (10) de mémoire vive résistive de la matrice mémoire, le premier potentiel électrique V1 et le deuxième potentiel électrique V2 sont propres à chaque dispositif de mémoire vive résistive ;
- lors de chaque étape (102) de forming de chaque dispositif (10) de mémoire vive résistive de la matrice mémoire, le premier potentiel électrique V1' et le deuxième potentiel électrique V2' sont propres à chaque dispositif de mémoire vive résistive.

10. Procédé selon la revendication 8 **caractérisé en ce qu'**il comporte une étape dite « de pré-forming général » selon laquelle, la matrice mémoire étant dans un premier état isolant moyen et présentant une première résistance moyenne, un même premier potentiel électrique est appliqué sur la première électrode (E1) et un même deuxième potentiel électrique est appliqué sur la deuxième électrode (E2) de chaque dispositif (10) de mémoire vive résistive de la matrice mémoire pour la formation d'un chemin localisé (11) de lacunes d'oxygène (12) entre les première et deuxième électrodes de chaque dispositif de mémoire vive résistive de la matrice mémoire, la matrice mémoire à l'issue de ladite étape de pré-forming général étant dans un deuxième état isolant moyen et présentant une deuxième résistance moyenne inférieure à la première résistance moyenne.

## Patentansprüche

1. Verfahren zur Bildung eines ersten leitenden Glühfadens (13) in einer ohmschen Arbeitsspeichervorrichtung (10), wobei die ohmsche Arbeitsspeichervorrichtung umfasst:
(i) eine erste Elektrode (E1), bezeichnet als "inerte Elektrode";
(ii) einen festen Elektrolyt aus Metalloxid (ML);
(iii) eine zweite Elektrode (E2), bezeichnet als "lösliche Elektrode", wobei die ersten und zweiten Elektroden jeweils auf jeder Seite des genannten festen Elektrolyts aus Metalloxid (ML) angeordnet sind, wobei die zweite Elektrode (E2) geeignet ist, mobile Ionen (14) zu liefern, die in dem festen Elektrolyt aus Metalloxid (ML) zu der ersten Elektrode (E1) zirkulieren, um einen leitenden Glühfaden (13) zwischen der ersten und zweiten Elektrode zu formen, wenn eine Potenzialdifferenz zwischen der ersten und zweiten Elektrode angewendet wird;
(iv) eine Schnittstellenschicht (INT), umfassend ein Metalloxid, wobei sich die Schnittstellenschicht (INT) wenigstens teilweise auf der ersten Elektrode (E1) erstreckt, wobei sich das feste Elektrolyt aus Metalloxid (ML) wenigstens teilweise auf der Schnittstellenschicht (INT) erstreckt;
wobei das Verfahren **dadurch gekennzeichnet ist, dass** das Verfahren umfasst: (a) einen Schritt (101), bezeichnet als "Preforming", gemäß dem die ohmsche Arbeitsspeichervorrichtung sich in einem ersten Isolationszustand befindet und einen ersten Widerstand R1 aufweist, ein erstes elektrisches Potenzial V1 auf die erste Elektrode (E1) angewendet ist und ein zweites elektrisches Potenzial V2 auf die zweite Elektrode (E2) für die Bildung eines lokalisierten Pfades (1) aus Sauerstofflücken (12) zwischen der ersten und zweiten Elektrode (11) angewendet ist, wenn das zweite elektrische Potenzial V2 kleiner ist als das erste elektrische Potenzial V1, wobei die ohmsche Speichervorrichtung nach Abschluss des genannten Preforming-Schritts sich in einem zweiten isolierenden Zustand befindet und einen zweiten Widerstand R2 aufweist, der kleiner ist als der erste Widerstand R1;
- einen Schritt (102), bezeichnet als "Deforming", gemäß dem ein erstes elektrisches Potenzial V1' auf die erste Elektrode (E1) angewendet ist und ein zweites elektrisches Potenzial V2' auf die zweite Elektrode (E2) angewendet ist, wenn die ohmsche Speichervorrichtung im zweiten isolierenden Zustand ist, wobei das zweite elektrische Potenzial V2' größer ist als das erste elektrische Potenzial V1' für die Bildung des leitenden Glühfadens (6) zwischen der ersten und zweiten Elektrode, wobei die ohmsche Arbeitsspeichervorrichtung nach Abschluss des genannten Forming-Schritts in einem leitenden Zustand ist.

2. Verfahren gemäß dem voranstehenden Anspruch, **dadurch gekennzeichnet, dass** das Metalloxid der Schnittstellenschicht (INT) ein unterstöchiometrisches Metalloxid mit der Formel MOₓ ist, wobei M ein Metall, O der Sauerstoff und 1 < x < 2 sind.

3. Verfahren gemäß dem voranstehenden Anspruch, **dadurch gekennzeichnet, dass** 1,6 < x < 1,9 ist.

4. Verfahren gemäß irgendeinem der voranstehenden Ansprüche, **dadurch gekennzeichnet, dass** das Metalloxid der Schnittstellenschicht (INT) ein Metalloxid eines Übergangsmetalls der Gruppen 3, 4, 5, oder 6 des Periodensystems der Elemente ist.

5. Verfahren gemäß dem voranstehenden Anspruch, **dadurch gekennzeichnet, dass** das Übergangsmetall der Gruppen 3, 4, 5 oder 6 des Periodensystems der Elemente Titan Ti, Hafnium Hf oder Zirconium Zr ist.

6. Verfahren gemäß irgendeinem der voranstehenden Ansprüche, bei dem die Schnittstellenschicht (INT) sich gemäß einer Referenzebene erstreckt, **dadurch gekennzeichnet, dass** die Schnittstellenschicht (INT) eine zwischen 0,5 nm und 2 nm inbegriffene Dicke aufweist, wobei die genannte Dicke gemäß einer Richtung gemessen ist, die zur genannten Referenzebene deutlich lotrecht ist.

7. Verfahren gemäß dem voranstehenden Anspruch, **dadurch gekennzeichnet, dass** der Wert des ersten elektrischen Potenzials V1, der auf die erste Elektrode (E1) angewendet ist, und der Wert des zweiten Potenzials V2, der auf die zweite Elektrode (E2) angewendet ist, bei dem Preforming-Schritt (101) derart ausgewählt sind, dass das Verhältnis R1/R2 des ersten Widerstandes R1 zu dem zweiten Widerstand R2 in der Größenordnung von 10³ ist.

8. Programmierverfahren einer Speichermatrix, umfassend eine Vielzahl von ohmschen Arbeitsspeichervorrichtungen (10), wobei das genannte Verfahren für jede ohmsche Arbeitsspeichervorrichtung (10) der Speichermatrix einen Umsetzungsschritt des ersten des ersten Bildungsverfahrens des leitenden Glühfadens in einer ohmschen Arbeitsspeichervorrichtung gemäß irgendeinem der Ansprüche 1 bis 7 umfasst.

9. Verfahren gemäß dem voranstehenden Anspruche, **dadurch gekennzeichnet, dass**:
(i) bei jedem Preforming-Schritt (101) jeder ohmschen Arbeitsspeichervorrichtung der Speichermatrix (10) das erste elektrische Potenzial V1 und das zweite elektrische Potenzial V2 zu jeder ohmschen Arbeitsspeichervorrichtung gehören;
(ii) bei jedem Deforming-Schritt (102) jeder ohmschen Arbeitsspeichervorrichtung (10) der Speichermatrix das erste elektrische Potenzial V1' und das zweite elektrische Potenzial V2' zu jeder ohmschen Arbeitsspeichervorrichtung gehören.

10. Verfahren gemäß Anspruch 8, **dadurch gekennzeichnet, dass** es einen Schritt umfasst, bezeichnet als "allgemeines Preforming", gemäß dem die Speichermatrix in einem ersten mittleren isolierenden Zustand ist und einen ersten mittleren Widerstand aufweist, ein und dasselbe erste elektrische Potenzial auf die erste Elektrode (E1) angewendet ist und ein und dasselbe zweite elektrische Potenzial auf die zweite Elektrode (E2) jeder ohmschen Arbeitsspeichervorrichtung (10) der Speichermatrix für die Bildung eines lokalisierten Pfades (11) von Sauerstofflücken zwischen der ersten und zweiten Elektrode jeder ohmschen Arbeitsspeichervorrichtung der Speichermatrix angewendet ist, wobei die Speichermatrix nach Abschluss des genannten allgemeinen Preforming-Schritts in einem zweiten mittleren isolierenden Zustand ist und einen zweiten mittleren Widerstand aufweist, der kleiner ist als der erste mittlere Widerstand.

## Claims

1. A method for first forming a conductive filament (13) in a resistive random access memory device (10), the resistive random access memory device including:
- a first electrode (E1), called an "inert electrode";
- a metal oxide solid electrolyte (ML);
- a second electrode (E2), called a "soluble electrode", the first and second electrodes being respectively arranged on either side of said metal oxide solid electrolyte (ML), the second electrode (E2) being able to provide mobile ions (14) flowing in the metal oxide solid electrolyte (ML) to the first electrode (E1) to form a conductive filament (13) between the first and second electrodes when a potential difference is applied between the first and second electrodes;
- an interface layer (INT) comprising a metal oxide, the interface layer (INT) extending at least partially on the first electrode (E1), the metal oxide solid electrolyte (ML) extending at least partially on the interface layer (INT);
the method being **characterised in that** it comprises:
- a so-called "pre-forming" step (101) in which, the resistive random access memory device being in a first insulating state and having a first resistance R1, a first electric potential V1 is applied to the first electrode (E1) and a second electric potential V2 is applied to the second electrode (E2), the second electric potential V2 being lower than the first electric potential V1, for forming a localised path (11) of oxygen vacancies (12) between the first and second electrodes, the resistive random access memory device at the end of said pre-forming step being in a second insulating state and having a second resistance R2 lower than the first resistance R1;
- a so-called "forming" step (102) in which, the resistive random access memory device being in a second insulating state, a first electric potential V1' is applied to the first electrode (E1) and a second electric potential V2' is applied to the second electrode (E2), the second electric potential V2' being higher than the first electric potential V1', for forming the conductive filament (6) between the first and second electrodes, the resistive random access memory device at the end of said forming step being in an ON state.

2. The method according to the preceding claim, **characterised in that** the metal oxide of the interface layer (INT) is a sub-stoichiometric metal oxide of the formula MOₓ, with M a metal, O oxygen and 1 < x < 2.

3. The method according to the preceding claim, **characterised in that** 1.6 < x <1.9.

4. The method according to any of the preceding claims, **characterised in that** the metal oxide of the interface layer (INT) is a metal oxide from a transition metal of groups 3, 4, 5 or 6 of the periodic table of the elements.

5. The method according to the preceding claim, **characterised in that** the transition metal of groups 3, 4, 5 or 6 of the periodic table of the elements is titanium Ti, hafnium Hf or zirconium Zr.

6. The method according to any of the preceding claims, wherein the interface layer (INT) extends along a reference plane, **characterised in that** the interface layer (INT) has a thickness between 0.5 nm and 2 nm, said thickness being measured along a direction substantially perpendicular to said reference plane.

7. The method according to the preceding claim, **characterised in that** during the pre-forming step (101), the value of the first electric potential V1 which is applied to the first electrode (E1) and the value of the second electric potential V2 which is applied to the second electrode (E2) are chosen such that the ratio R1/R2 of the first resistance R1 to the second resistance R2 is in the order of 10³.

8. A method for programming a memory array including a plurality of resistive random access memory devices (10), said method including, for each resistive random access memory device (10) of the memory array, a step of implementing the method for first forming the conductive filament in a resistive random access memory device according to any of claims 1 to 7.

9. The method according to the preceding claim, **characterised in that**:
- during each step (101) of pre-forming each resistive random access memory device (10) of the memory array, the first electric potential V1 and the second electric potential V2 are peculiar to each resistive random access memory device;
- during each step (102) of forming each resistive random access memory device (10) of the memory array, the first electric potential V1' and the second electric potential V2' are peculiar to each resistive random access memory device.

10. The method according to claim 8, **characterised in that** it includes a so-called "general pre-forming" step in which, the memory array being in a first mean insulating state and having a first average resistance, a same first electric potential is applied to the first electrode (E1) and a same second electric potential is applied to the second electrode (E2) of each resistive random access memory device (10) of the memory array for forming a localised path (11) of oxygen vacancies (12) between the first and second electrodes of each resistive random access memory device of the memory array, the memory array at the end of said general pre-forming step being in a second average insulating state and having a second average resistance lower than the first average resistance.
